# EUROPÄISCHE PATENTSCHRIFT

(11) **EP 0 685 087 B1**
(45) Veröffentlichungstag und Bekanntmachung des Hinweises auf die Patenterteilung: **13.11.1996**
(21) Anmeldenummer: 94906827.4
(22) Anmeldetag: 03.02.1994
(51) Int. Cl.: G06F 11/24

(54) **SELBSTTESTVERFAHREN FÜR NICHT-REGULÄRE CMOS-SCHALTSTRUKTUREN MIT HOHER DEFEKTERFASSUNG**
AUTO-TEST PROCESS FOR NON-REGULAR CMOS CIRCUIT STRUCTURES WITH HIGH FAULT DETECTION
PROCEDE DE CONTROLE AUTOMATIQUE POUR STRUCTURES DE CIRCUIT CMOS NON REGULIERS A HAUT POUVOIR DE DETECTION DE DEFAUTS

(30) Priorität: 20.02.1993 DE 4305288
(43) Veröffentlichungstag der Anmeldung: 06.12.1995
(73) Patentinhaber: ROBERT BOSCH GMBH, 70442 Stuttgart (DE)
(72) Erfinder: KESEL, Frank, D-72793 Pfullingen (DE)
(86) Internationale Anmeldenummer: DE9400103
(87) Internationale Veröffentlichungsnummer: WO9419745

(56) Entgegenhaltungen:
- IEEE JOURNAL OF SOLID-STATE CIRCUITS Bd. 27, Nr. 3 , 1. März 1992 , NEW YORK US Seiten 425 - 428 MALY W. ET AL. 'Built-in current testing'
- PROCEEDINGS INTERNATIONAL TEST CONFERENCE 1991 1. September 1991 , BALTIMORE, USA Seiten 623 - 632 AITKEN R. ET AL. 'Fault location with current monitoring'
- PROCEEDINGS INTERNATIONAL TEST CONFERENCE 1990 1. September 1990 , WASHINGTON DC, USA Seiten 436 - 443 FERGUSON F.J. ET AL. 'Testing for parametric faults in static CMOS circuits'
- PROCEEDINGS OF THE IEEE 1989 CUSTOM INTEGRATED CIRCUITS CONFERENCE 15. Mai 1989 , SAN DIEGO, CA, USA Seiten 22.1.1 - 22.1.4 NIGH P. ET AL. 'A self-testing ALU using built-in current sensing'
- IEEE JOURNAL OF SOLID-STATE CIRCUITS Bd. 27, Nr. 3, 1. März 1992, New York, US, SS. 425-428; MALY W. et al.: 'Built-in current testing'
- PROCEEDINGS INTERNATIONAL TEST CONFERENCE 1991 1. September 1991, Baltimore, USA, SS. 623-632; AITKEN R. et al.: 'Fault location with current monitoring'
- PROCEEDINGS INTERNATIONAL TEST CONFERENCE 1990 1. September 1990, Washington DC, USA, SS. 436-443; FERGUSON F.J. et al.: 'Testing for parametric faults in static CMOS circuits'
- PROCEEDINGS OF THE IEEE 1989 CUSTOM INTEGRATED CIRCUITS CONFERENCE 15. Mai 1989, San Diego, CA, USA, SS. 22.1.1-22.1.4; NIGH P. et al.: 'A self-testing ALU using built-in current sensing'

## Beschreibung

### Stand der Technik

Die Erfindung betrifft ein Selbsttestverfahren für nicht-reguläre CMOS-Schaltstrukturen mit hoher Defekterfassung nach dem Oberbegriff des Anspruchs 1.

Ein bekanntes Selbsttestverfahren (Koenemann, B.; Mucha, J.; Zwiehoff, G.; Built-In Logic Block Observation Techniques; IEEE Int'l Test Conference, 1979) verwendet linear rückgekoppelte Schieberegister zur Erzeugung von Echtzeit-Teststimuli und zur Komprimierung der Testantworten. Es wird dabei der Datenfluß an internen Testpunkten von komplexen, digitalen Schaltungen beobachtet. Da bei diesem Verfahren die Reaktion der Schaltung auf die Teststimuli nur an den primären Ausgängen der Schaltung erfaßt wird, können Brückenfehler nicht sicher, bestimmte stuck-at-Fehler nur schwer und redundante stuck-at-Fehler gar nicht erkannt werden. In anderen bekannten Selbsttestverfahren (Chang, T.; Wang, C.; Hsu, J.; Two Schemes for Detecting CMOS Analog Faults; IEEE Journal of Solid-State Circuits, Vol. 27, No. 2, Feb. 1992; oder Favalli M. et al.; Novel Design for Testability Schemes for CMOS IC's; IEEE Journal of Solid-State Circuits, Vol. 25, No. 5, Oct. 1990) werden eingebaute Stromsensoren zur Sensierung der statischen Stromaufnahme (Iddq-Monitoring) verwendet.

### Vorteile der Erfindung

Das erfindungsgemäße Verfahren wie in Patentanspruch 1 definiert ist, besteht aus einer Kombination des Selbsttests mit linear rückgekoppelten Schieberegistern mit dem Selbsttestprinzip der Sensierung der statischen Stromaufnahme in Verbindung mit einer Partitionierung der zu testenden Schaltung (kombinatorische Logik). Es können verschiedene Testmodi, abhängig von der Beschaltung (von PH1-PH3) realisiert werden. Zunächst ist zu unterscheiden zwischen einem "logischen Test" und einem "Iddq-Test" (Sensierung der statischen Stromaufnahme). Beim logischen Test wird die Reaktion der Schaltung auf die Teststimuli des Eingangsregisters an den primären Ausgängen der Schaltung (Ausgangsregister) beobachtet. Dieser Test wird in Echtzeit ausgeführt und ermöglicht die Erkennung von stuck-at-, stuck-open-, Verzögerungsfehlern und zum Teil auch von Brückenfehlern.

Die abhängigen Ansprüche 2 bis 5 spezifieren zweckmäßige Ausgestaltungen des Gegenstandes des Haupanspruchs. Beim Iddq-Test wird die Reaktion der Schaltung durch die Teilstromsensoren beobachtet. Dabei können Kurzschlußfehler (stuck-at-Fehler und Brückenfehler) bis zu einer maximalen Größe R_{smaX} sicher erkannt werden, sofern sie stimuliert wurden. Da die Beobachtung beim Iddq-Test durch den Stromsensor erfolgt, muß der Fehler nur stimuliert werden (Steuerbarkeit). Dies führt durch den Wegfall des Beobachtbarkeitsproblems, welches beim logischen Test auftritt, zu einer erhöhten Fehlerentdeckungsrate pro Testvektor bzw. zu einer Reduktion der Gesamtzahl der benötigten Testvektoren.

Weiterhin ergeben sich durch den Stromsensor folgende Vorteile:

Sichere Erkennbarkeit von Brückenfehlern, welche in CMOS-Schaltungen einen hohen Anteil der Defekte darstellen,

A-Priori-Erkennung hochohmiger Kurzschlußfehler, bevor diese sich als logische Fehler auswirken, z.B. Gate-Oxide-Shorts, und damit Erhöhung der Zuverlässigkeit der Schaltung,

Erkennung redundanter stuck-at-Fehler.

Die Kombination beider Testprinzipien, des "logischen Tests" und des "Iddq-Tests" bietet somit als Vorteil eine hohe Erfaßbarkeit von parametrischen (Verzögerungsfehler, hochomige Brückenfehler) und funktionalen Fehlern (stuck-at-, stuck-open- und niederohmigen Brückenfehlern). Dieser Vorteil ist mit einem Hardware-Mehraufwand von ca. 25 % günstig realisierbar. Dabei ergibt sich ein Trade-Off zwischen dem Hardware-Mehraufwand, dem Widerstand Rₛₘₐₓ des erkennbaren Kurzschlußfehlers und der Testgeschwindigkeit für den Stromsensor.

In einer weiterführenden Ausgestaltung der Erfindung wird gegenüber den bekannten Ausführungen für den Stromsensor durch Vorladung eines lokalen Knotens (N1) und Auswertung mittels eines NOR-Gatters eine Erhöhung der Testgeschwindigkeit bei geringem Schaltungsaufwand bewirkt. Die betrachteten, hochohmigen Knoten (VVDD und N1) sind lokale Knoten, die kurz ausgeführt werden können, so daß dadurch die Störsicherheit des Testverfahrens gewährleistet ist. Die Auswertung durch das globale NOR-Gatter erfolgt aus diesen Gründen (mittels TPX) ratiometrisch.

### Zeichnung

Anhand einer Zeichnung wird die Erfindung näher erläutert.

Es zeigen:
- Fig. 1: ein Blockschaltbild eines Selbsttestverfahrens,
- Fig. 2: eine Blockschaltbilddarstellung des Stromsensormoduls aus Fig. 1,
- Fig. 3: eine Schaltung eines Teil-Stromsensors aus Fig. 2 und
- Fig. 4: ein Taktschema.

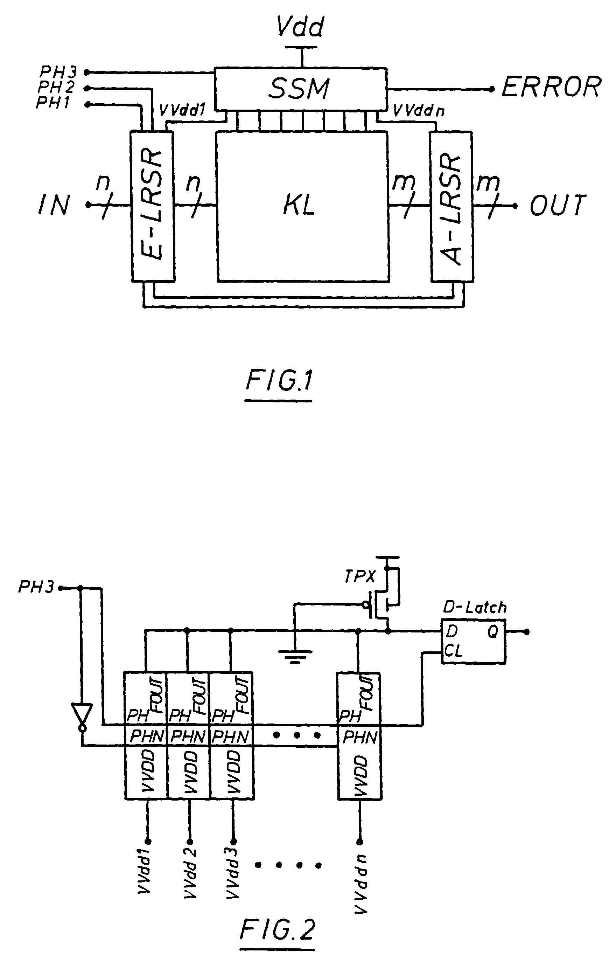

In Fig. 1 ist ein Blockschaltbild für das Selbsttestverfahren dargestellt, wobei die zu testende Schaltung aus einem Eingangsregister E-LRSR, einem Ausgangsregister A-LRSR und einer kombinatorischen Logik KL besteht. Das Eingangsregister E-LRSR und das Ausgangsregister A-LRSR sind multifunktionale, linear rückgekoppelte Schieberegister.

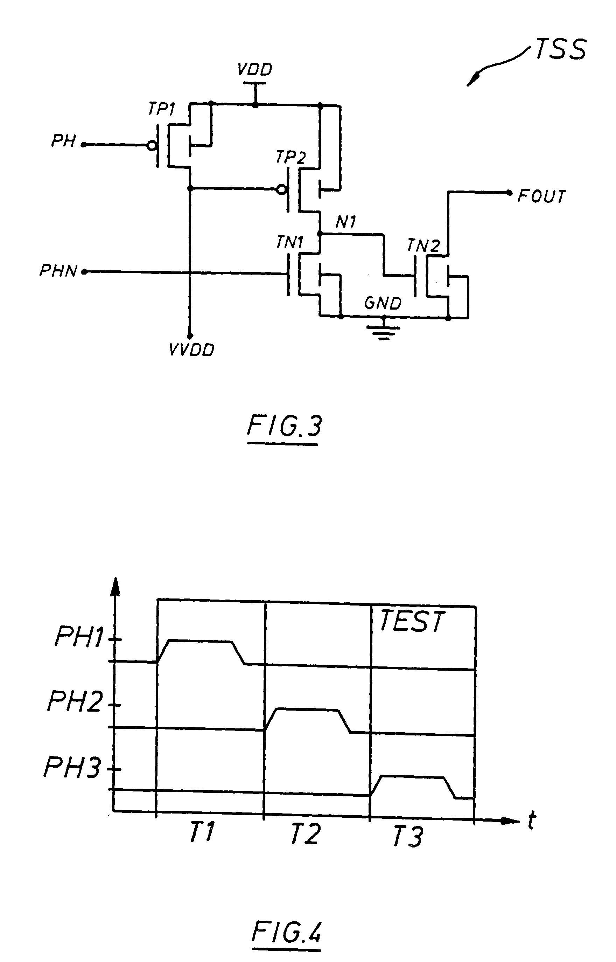

Die kombinatorische Logik KL ist als statische CMOS-Logik ausgeführt und in einzelne Blöcke partitioniert, wobei deren Energie zuführungen getrennt über einen jeweils zugeordneten Teilstromsensor TSS (Fig. 3) geführt werden.

Die Teilstromsensoren TSS sind zu dem in Fig. 1 dargestellten Stromsensormodul SSM zusammengefaßt.

Die Teilstromsensoren TSS bzw. das Stromsensormodul SSM sind jeweils mit dem Eingangsregister E-LRSR, den partitionierten Blöcken der kombinatorischen Logik KL und dem Ausgangsregister A-LRSR entsprechend den Anschlüssen VVdd1 ... VVddn verbunden.

Über die Anschlüsse PH1, PH2 und PH3 werden entsprechende Taktsignale vorgegeben, wobei PH1 und PH2 am Eingangsregister E-LRSR und PH3 am Stromsensormodul SSM angeschlossen ist. Am Ausgang des Stromsensormoduls wird im Falle eines erfaßten Fehlers ein Fehlersignal ERROR zur Verfügung gestellt.

In Fig. 2 ist das Stromsensormodul SSM detaillierter dargestellt und besteht aus Teil-Stromsensoren TSS, deren Schaltung in Fig. 3 gezeigt ist.

Die Ausgangsstufen (TN2) der Teilstromsensoren TSS bilden mit der Stufe TPX ein NOR-Gatter.

Die Teilstromsensoren TSS bestehen jeweils gemäß Fig. 3 aus einem ersten Transistor TP1 und aus Sensierungstransistoren, nämlich einem zweiten Transistor TP2, einem dritten Transistor PN1 und einem vierten Transistor TN2. Der erste Transistor TP1 ist sowohl an ein Taktsignal PH als auch an die Energiezuführung VDD und einen Knoten VVDD angeschlossen, wobei der Knoten VDDD mit einem Register E-LRSR oder A-LRSR oder einem Block der kombinatorischen Logik LK verbunden ist (sh. Fig. 2).

Der zweite Transistor TP2 und der dritte Transistor TN1 sind in Reihe dem ersten Transistor TP1 nachgeschaltet, wobei der zweite Transistor TP2 eingangsseitig ebenfalls an den Knoten VDD und der dritte Transistor TP2 eingangsseitig an ein Taktsignal PHN angeschlossen sind.

Ein lokaler Knoten N1 zwischen dem zweiten Transistor TP2 und dem dritten Transistor TN1 ist mit dem Eingang des vierten Transistors TN2 verbunden, dessen Ausgang mit der Schaltstufe TPX aus Fig. 2 das NOR-Gatter bildet, dem ein D-Latch nachgeschaltet ist.

In Fig. 4 ist ein Taktschema für die erzeugten Taktsignale PH1, PH2 und PH3 aufgetragen, wobei die ersten beiden Zeitphasen T1 und T2 eine Betriebsphase und die dritte Zeitphase T3 eine Testphase darstellen sollen.

Die in den Fig. 1 bis 4 gezeigte Anordnung hat folgende Funktion:

Der erste Transistor TP1 der Teilstromsensoren nach Fig. 3 ist im Normalbetrieb der Schaltung ständig eingeschaltet. Im Testbetrieb wird ein Testmuster durch das Eingangsregister E-LRSR über die Taktsignale PH1 und PH2 an die kombinatorische Logik KL angelegt. Dabei sind der erste Transistor TP1 und der dritte Transistor TN1 eingeschaltet und der zweite Transistor TP2 und vierte Transistor TN2 gesperrt. Der lokale Knoten N1 wird damit auf 0 Volt vorgeladen, entsprechend einem Taktsignal PH3.

Nachdem die transienten Ströme in der angeschlossenen Schaltung abgeklungen sind, entsprechend einer Laufzeit des kritischen Pfades, werden der erste Transistor TP1 und der dritte Transistor TN1 ausgeschaltet.

Ist die Schaltung fehlerfrei, bleibt der Knoten VVDD hochohmig und der zweite Transistor TP2 und vierte Transistor TN2 schalten nicht durch. Bei einem Fehler sinkt jedoch das Potential am Knoten VVDD unter die Schaltschwelle des zweiten Transistors TP2, so daß dieser durchschaltet und dadurch den lokalen Knoten N1 auflädt, worauf der vierte Transistor TN2 durchschaltet und über das NOR-Gatter eine Fehlermeldung erfolgt. Insbesondere wird als Fehlermeldung eine logische "0" bei einem Kurzschlußfehler in einem oder mehreren Blöcken der kombinatorischen Logik LK oder den Registern E-LRSR oder A-LRSR in das D-Latch eingespeist.

Das Eingangsregister E-LRSR erzeugt im Testbetrieb Pseudozufallsmuster und das Ausgangsregister A-LRSR komprimiert die Testantworten der kombinatorischen Logik zu einer Signatur, während das Stromsensormodul SSM die Aufgabe hat, festzustellen, ob Kurzschluß-Fehler (stuck-at-Fehler und Brückenfehler) in der Schaltung oder den Registern vorhanden sind.

Die Sensierung der statischen Stromaufnahme wird durch ein dynamisches Meßverfahren bewirkt, welches die Entladung der Kapazitäten am Knoten VVDD über den Widerstand des Kurzschlußfehlers mißt. Dabei hängt die Größe des maximal erkennbaren Kurzschlußfehler-Widerstandes Rₛₘₐₓ von der Dauer der Testphase T3 (Fig. 4) ab. Daraus ergibt sich der Trade-Off für die Partitionierung der zu testenden Schaltung in Blöcke und die Dimensionierung des Stromsensors:

Der erste Transistor TP1 muß so dimensioniert werden, daß durch seinen Bahnwiderstand Rₒₙ ein vorgegebener Spannungsabfall Δ Uₘₐₓ bei einer maximalen transienten Stromaufnahme Iₜᵣₘₐₓ des Schaltungsblocks nicht überschritten wird. Eine Vergrößerung von TP1 bewirkt jedoch einen Anstieg seiner parasitären Kapazitäten und beeinflußt damit die Testgeschwindigkeit D3 bei vorgegebenem Rₛₘₐₓ oder Rₛₘₐₓ bei vorgegebenem T3. Iₜᵣₘₐₓ wird daher für die kleinste Blockgröße der Schaltung bestimmt und nach Vorgabe von Δ Uₘₐₓ der minimale Wert für TP1 bestimmt. Daraus ergibt sich dann der Trade-Off zwischen den Parametern Blockgröße/Hardwareaufwand-Testgeschwindigkeit-Rₛₘₐₓ. Der zweite Transistor TP2 wird klein gewählt, um die kapazitive Belastung am Knoten VVDD aus obigen Gründen möglichst klein zu halten. Der dritte Transistor TN1 kann ebenso minimal ausgelegt werden. Der vierte Transistor TN1 wird zusammen mit TPX so ausgelegt, daß das NOR-Gatter möglichst schnell durchschaltet.

Mit der dargestellten Anordnung können verschiedene Testmodi, abhängig von der Beschaltung von PH1 - PH3 realisiert werden, wobei beim "logischen Test" die Reaktion der Schaltung auf die Teststimuli des Eingangsregisters E-LRSR im Ausgangsregister A-LRSR beobachtet wird und beim "Iddq-Test" die Reaktion durch den Stromsensor beobachtet wird.

Wenn beispielsweise bei einem 9Bit-Addierer eine Fehlersimulation bezüglich der erwähnten Fehlermodelle durchgeführt wird, ergibt sich beim Iddq-Test eine Fehlererfassung von 100 % für stuck-at- und Brückenfehler nach ca. 10 Testvektoren, welche mittels der Register erzeugt werden. Dies bedeutet, bei einer 20 MHz-Taktfrequenz eine Testzeit von 500 ns. Nach 100 Testvektoren ergab sich im logischen Test eine Fehlererfassung von ca. 95 % für stuck-open-Fehler und Verzögerungsfehler, entsprechend einer Testzeit von 5 µs.

Der Stromsensor ist durch Einführung einer zusätzlichen Taktphase T3 auch zur Online-Beobachtung ("concurrent check") einsetzbar. Die zusätzliche Taktphase muß eingeführt werden, da aufgrund des Funktionsprinzips des Stromsensors (floatende VDD) beim Iddq-Test keine sichere logische Funktion gewährleistet werden kann. Es lassen sich damit folgende Testmodi realisieren (sh. auch Fig. 4):
Ia) Offline-BIST (Built-In Self-Test): Wird auf eine zusätzliche Taktphase PH3 verzichtet, so wird PH2 für die Stromsensierung genutzt. Daher müssen logischer Test und Iddq-Test in zwei Testläufen durchgeführt werden. Dabei muß u.U. im Iddq-Test mit verringerter Taktfrequenz getestet werden, da die zu testende Schaltung eingeschwungen sein muß (kritischer Pfad), bevor die statische Stromaufnahme sensiert werden kann.
Ib) Offline-BIST: Wird die zusätzliche Taktphase PH3 eingeführt, so können der logische Test und der Iddq-Test gleichzeitig durchgeführt werden. Der logische Test findet dann entsprechend Abbildung 4 in den Phasen T1 und T2, entsprechend den Taktphasen PH1 und PH2 statt; der Iddq-Test wird in T3 durchgeführt.
II) Online-Test (concurrent check): Hierzu wird in jedem Fall die zusätzliche Taktphase PH3 benötigt. Die logische Funktion der Schaltung ergibt sich in T1 und T2 (Taktphase PH1 und PH2); in T3 wird geprüft, ob ein Kurschlußfehler in der Schaltung vorliegt.

Der Stromsensor kann komplementär zur Fig. 3 auch als GND-Sensor ausgelegt werden. Weiterhin läßt er sich auch in ein-oder mehrphasigen Taktsystemen einsetzen.

## Patentansprüche

1. Verfahren zum Selbsttest von CMOS-Schaltungen durch Bestimmung der statischen Stromaufnahme, bei dem die CMOS-Schaltung über einen ersten Transistor (TP1) mit einem ersten Betriebsspannungsanschluß (VDD) verbunden ist, wobei zwischen dem ersten Transistor (TP1) und der CMOS-Schaltung ein Knoten (VVDD) angeordnet ist, wobei in einem statischen Zustand der CMOS-Schaltung der erste Transistor (TP1) geöffnet wird , wobei der Knoten (VVDD) mit dem Gate eines zweiten Transistors (TP2) verbunden ist, wobei der Schaltpunkt des zweiten Transistors so gewählt wird, daß bei einem vorgegebenen Potential am Knoten (VVDD) der zweite Transistor (TP2) schaltet, wobei ein lokaler Knoten (N1) vorgesehen ist, der durch den zweiten Transistor (TP2) mit dem ersten Betriebsspannungsanschluß (VDD) verbindbar ist, wobei ein dritter Transistor (TN1) vorgesehen ist, durch den der lokale Knoten (N1) mit einem zweiten Betriebsspannungsanschluß (GND) verbindbar ist, dadurch gekennzeichnet, daß in einem Normalbetrieb der CMOS-Schaltung der lokale Knoten (N1) mit dem zweiten Betriebsspannungsanschluß (GND) verbunden wird und daß der lokale Knoten (N1) zur Bestimmung der statischen Stromaufnahme der CMOS-Schaltung vom zweiten Betriebsspannungsanschluß (GND) getrennt wird.

2. Verfahren nach Anspruch 1, dadurch gekennzeichnet, daß der lokale Knoten (N1) mit dem Gate eines vierten Transistors (TN2) verbunden wird.

3. Verfahren nach Anspruch 2, dadurch gekennzeichnet, daß mehrere CMOS-Schaltungen zu einer kombinatorischen Logik zusammengefaßt werden, daß durch jeden der vierten Transistoren der CMOS-Schaltungen eine gemeinsame Leitung mit dem zweiten Betriebsspannungsanschluß (GND) verbindbar ist, daß ein weiterer Transistor (TPX) vorgesehen ist, der mit den vierten Transistoren ein Gatter bildet, welches ein Signal erzeugt, wenn einer der vierten Transistoren (TN2) die gemeinsame Leitung mit dem zweiten Betriebsspannungsanschluß (GND) verbindet.

4. Verfahren nach Anspruch 3, dadurch gekennzeichnet, daß die kombinatorische Logik für den Selbsttest von einer Pseudo-Zufallsfolge, die durch ein linear rückgekoppeltes Register erzeugt wird, angesteuert wird.

5. Verfahren nach Anspruch 3, dadurch gekennzeichnet, daß die kombinatorische Logik durch ein linear rückgekoppeltes Eingangsschieberegister und ein linear rückgekoppeltes Ausgangsschieberegister auf seine logische Funktion hin getestet wird, indem durch das linear rückgekoppeltes Eingangsregister eine Pseudo-Zufallsfolge an die kombinatorische Logik angelegt wird und durch das linear rückgekoppelte Ausgangsregister die Reaktionen der kombinatorischen Logik zu einer Signatur komprimiert wird und indem die Signatur mit einer Soll-Signatur verglichen wird.

## Claims

1. Method for the self-testing of CMOS circuits by determining the static current consumption, in which the CMOS circuit is connected to a first operating voltage connection (VDD) via a first transistor (TP1), a node (VVDD) being arranged between the first transistor (TP1) and the CMOS circuit, the first transistor (TP1) being turned on in a static state of the CMOS circuit, the node (VVDD) being connected to the gate of a second transistor (TP2), the switching point of the second transistor being selected in such a way that the second transistor (TP2) switches at a predetermined potential across the node (VVDD), a local node (N1) being provided which can be connected to the first operating voltage connection (VDD) by means of the second transistor (TP2), a third transistor (TN1) being provided, by means of which the local node (N1) can be connected to a second operating voltage connection (GND), characterized in that the local node (N1) is connected to the second operating voltage connection (GND) during normal operation of the CMOS circuit, and characterized in that the local mode (N1) is isolated from the second operating voltage connection (GND) in order to determine the static current consumption of the CMOS circuit.

2. Method according to Claim 1, characterized in that the local node (N1) is connected to the gate of a fourth transistor (TN2).

3. Method according to Claim 2, characterized in that a plurality of CMOS circuits are combined to form a combinational logic unit, in that a common line can be connected to the second operating voltage connection (GND) by each of the fourth transistors of the CMOS circuits, in that a further transistor (TPX) is provided, which forms, together with the fourth transistor, a gate which generates a signal when one of the fourth transistors (TN2) connects the common line to the second operating voltage connection (GND).

4. Method according to Claim 3, characterized in that the combinational logic unit for the self-testing is driven by a pseudorandom sequence generated by a linear feedback register.

5. Method according to Claim 3, characterized in that the combinational logic unit is tested by a linear feedback input shift register and a linear feedback output shift register with regard to its logic function in that a pseudorandom sequence is applied to the combinational logic unit by the linear feedback input register and in that the reactions of the combinational logic unit are compressed by the linear feedback output register to form a signature and in that the signature is compared with a desired signature.

## Revendications

1. Procédé de test automatique de circuits CMOS en définissant la prise de courant statique, selon lequel on relie le circuit CMOS par un premier transistor (TP1) à une première borne de tension de fonctionnement (VDD), et entre le premier transistor (TP1) et le circuit CMOS on a un noeud (VVDD), le premier transistor (TP1) étant ouvert lorsque le circuit CMOS est dans un premier état statique, le noeud (VVDD) étant relié à la grille d'un second transistor (TP2), le point de commutation du second transistor étant choisi pour que le second transistor (TP2) commute pour un potentiel prédéterminé sur le noeud (VVDD), un noeud local (Nl) étant prévu qui peut être relié par le second transistor (TP2) à la première borne de tension d'alimentation (VDD), un troisième transistor (TN1) pouvant relier le noeud local (N1) à une seconde borne de tension de fonctionnement (GND),
caractérisé en ce qu'
en fonctionnement normal du circuit CMOS, le noeud local (N1) est relié à la seconde borne de tension de fonctionnement (GND) et le noeud local (N1) est séparé de la seconde borne de tension de fonctionnement (GND) pour définir la prise de courant statique du circuit CMOS.

2. Procédé selon la revendication 1,
caractérisé en ce que
le noeud local (N1) est relié à la grille d'un quatrième transistor (TN2).

3. Procédé selon la revendication 2,
caractérisé en ce que
plusieurs circuits CMOS sont réunis en une logique combinatoire, et chacun des quatrièmes transistors des circuits CMOS peut relier une ligne commune à la seconde borne de tension de fonctionnement (GND), un autre transistor (TPX) formant une grille avec le quatrième transistor, générant un signal lorsque le quatrième transistor (TN2) relie la ligne commune à la seconde borne de tension de fonctionnement (GND).

4. Procédé selon la revendication 3,
caractérisé en ce que
la logique combinatoire est commandée pour le test automatique par une suite pseudo-aléatoire générée par un registre à couplage en réaction linéaire.

5. Procédé selon la revendication 3,
caractérisé en ce que
la logique combinatoire est testée par un registre d'entrée à couplage en réaction linéaire et un registre de sortie à couplage en réaction linéaire, pour sa fonction logique, et le registre d'entrée à couplage en réaction linéaire applique une suite pseudo-aléatoire à la logique combinatoire tandis que le registre de sortie à couplage en réaction linéaire comprime les réponses de la logique combinatoire en une signature, celle-ci étant comparée à une signature de consigne.
